# EUROPEAN PATENT APPLICATION

(11) **EP 2 811 251 A1**
(43) Date of publication of application: **10.12.2014**
(21) Application number: 13170378.7
(22) Date of filing: 04.06.2013
(51) Int. Cl.: F28D 15/02, H05K 7/20, F28F 9/02

(54) **Cooling apparatus**

(71) Applicant: ABB Research Ltd., 8050 Zürich (CH)
(72) Inventor: Agostini, Bruno, 5405 Baden Daetwill (CH); Elomaa, Heikki, 08500 Lohja (FI); Sundelin, Jari, 00380 Helsinki (FI); Laurila, Risto, 00380 Helsinki (FI)
(74) Representative: Kolster Oy Ab

(57) **Abstract**

The invention relates to an apparatus comprising an evaporator with a base plate (2) having a first surface for receiving a heat load from one or more electric components, tubes (4) that partly penetrate into the base plate (2) via a second surface of the base plate (2) for providing evaporator channels (6) which are embedded into the base plate (2) and condenser channels (7) which are located outside of the base plate (2). In order to obtain a compact and efficient apparatus the connecting parts include hollow sections (8, 9) located within the tubes (4), each hollow section (8, 9) connecting the channels (6, 7) of a tube (4) to each other in the vicinity of an end of the tube (4) in order to allow fluid to flow between the channels (6, 7) of the tube via the hollow section (8, 9).

## Description

### BACKGROUND OF THE INVENTION

### FIELD OF THE INVENTION

This invention relates to an apparatus with an evaporator for receiving a heat load from one or more electric components in order to provide adequate cooling for the components.

### DESCRIPTION OF PRIOR ART

Closed electric cabinets, such as cabinets containing drives controlling the operation of electric motors, typically employ cooling devices for ensuring that heat generated by the electric components do not raise the temperature inside the cabinets to a level where damage may occur.

These known cooling devices may consist of heat sinks or heat exchangers receiving heat loads from the electric components, and via which a cooling air flow passes for dissipating the heat load to the surrounding environment. Such traditional cooling devices typically consist of metal pieces without any kind of fluid circulation, or of devices with fluid circulation and which employ a pump for generating the fluid circulation.

Previously there also exists more efficient apparatuses for cooling electric components, such as thermosyphons, capable of circulating a cooling fluid without a need for a pump. It would be desirable to utilize such apparatuses also in old electric cabinets which have originally been manufactured to include traditional heat sinks or heat exchangers.

A problem with the more efficient apparatuses is, however, the shape and dimensions of the apparatus in question. Due to the shape and dimensions these more efficient known apparatuses cannot be utilized to the extent otherwise possible.

### SUMMARY OF THE INVENTION

An object of the present invention is to solve the above mentioned drawback and to provide an apparatus where the shape and dimensions of the apparatus place less restrictions on the installations where the apparatus can be utilized. These and other objects of the invention are solved with the apparatus of independent claims 1.

The use of connecting parts including hollow sections located within the tubes, which hollow sections connect the channels of a tube to each other in the vicinity of an end of the tube, makes it possible to obtain efficient circulation between evaporator channels and condenser channels without a need for a large fluid distribution element at the ends of the tubes. Therefore the shape and dimensions of the apparatus may be selected more freely than previously.

Preferred embodiments of the invention are disclosed in the dependent claims.

### BRIEF DESCRIPTION OF DRAWINGS

In the following the present invention will be described in closer detail by way of example and with reference to the attached drawings, in which

Figure 1 illustrates a working principle of an apparatus,

Figures 2 to 4 illustrate an apparatus,

Figures 5 to 8 illustrate a second embodiment of an apparatus, and

Figures 9 and 10 illustrate alternative tube designs.

### DESCRIPTION OF AT LEAST ONE EMBODIMENT

The apparatus 1 comprises an evaporator 2 including a base plate for receiving a heat load 3 from one or more electric components. The electric components may be directly attached to the evaporator of aluminum, for instance.

One or more tubes 4 with internal longitudinal walls 5 penetrate partly into the second surface 22 of the evaporator 2 such that at least one channel of the penetrating tubes is embedded in the base plate 2 to form an evaporator channel 6. Fluid located in this evaporator channel 6 (or evaporator channels 6) receives the heat load 3 via the base plate. Due to temperature rise and evaporation, the fluid flows upwards in the evaporator channel 6 in the illustrated example.

A hollow section 8 within each tube 4, in other words an end section of the tube where no internal walls are present, connects the channels 6 and 7 of each tube to each other in a first end 10 of the tubes 4 in order to allow fluid to flow between the channels 6 and 7 of the tubes 4.

The channels located outside the evaporator 2 are condenser channels 7. The fluid which has entered the condenser channels 7 is cooled while moving towards the second end 11 of the tubes 4. The cooling may be accomplished by transfer of heat from the fluid through the walls of the condenser channels 7 to the surrounding air.

A hollow section 9 within each tube 4, in other words an end section of the tube where no internal walls are present, connects the channels 7 and 6 of each tube to each other in the second end 11 of the tubes 4 in order to allow fluid to flow between the channels 7 and 6 of the tubes 4. Consequently, the cooled fluid is returned from the condenser channels 7 to the evaporator channels 6 for a new cycle. In practice, the returning fluid has condensed into a liquid state.

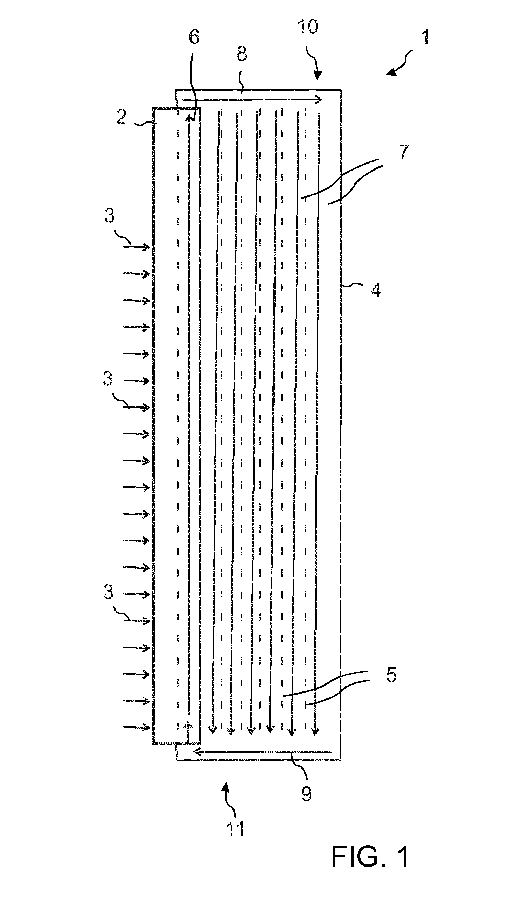

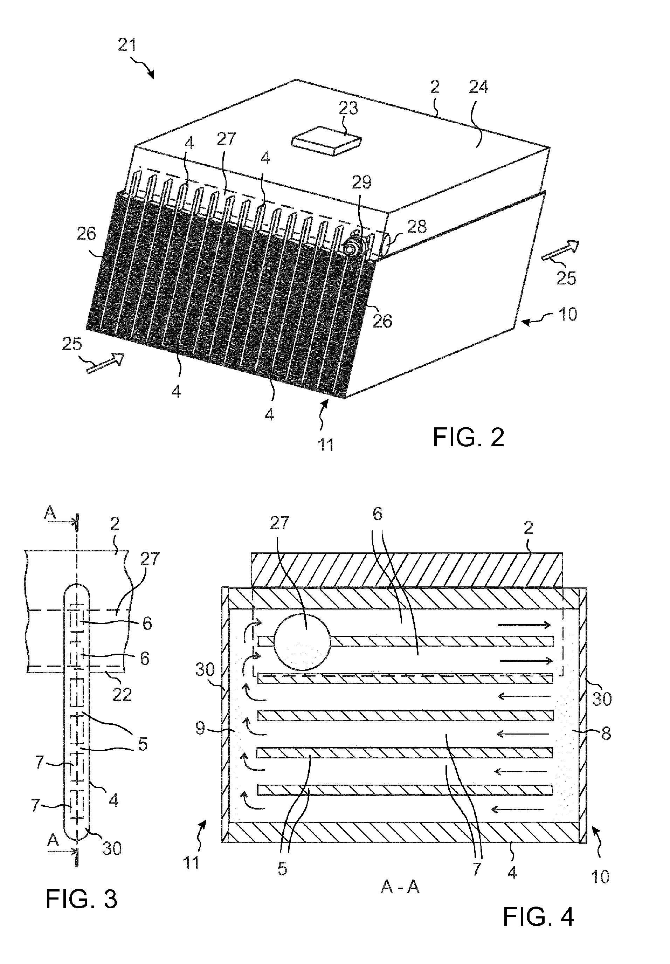

In the illustrated position the fluid circulation occurs without a pump due to gravity, the temperature differences and the density differences of the fluid (liquid/vapour) in different parts of the apparatus. In order to ensure efficient circulation of the fluid and to ensure that adequate circulation occurs also when the apparatus is in another position (such as in the horizontal position of Figures 2 to 4) than in the illustrated upright position, some of the channels 6 or 7 of the tube 4 may have capillary dimensions. In that case, if the condenser channels 7 returning fluid from the first end 10 of the apparatus to the second end 11 of the apparatus have capillary dimensions, a flow of fluid from the first end 10 to the second end 11 may take place also when the apparatus is in another position than the upright position illustrated in Figure 1. In this context "capillary dimensions" refers to channels that are capillary sized, in which case they have a size small enough so that bubbles can grow uniquely in a longitudinal direction (in other words in the flow direction as opposed to the radial direction) and thereby create a pulsating effect (bubble pumping or bubble lift effect) by pushing the liquid. In this example they are capillary sized so that no additional capillary structures are needed on their internal walls. The diameter of a channel which is considered capillary depends on the fluid that is used (boiling) inside. The following formula, for instance, can be used to evaluate a suitable diameter:

D = (sigma/(g*(rhol-rhov)))^0.5,

where sigma is the surface tension, g the acceleration of gravity, rhov the vapor density and rhol the liquid density. This formula gives values from 1 to 3 mm for R134a (Tetrafluoroethane), R145fa and R1234ze (Tetrafluoropropene), which are fluids suitable for use in the apparatus illustrated in the Figures.

Figures 2 to 4 illustrate an apparatus. The working principle and construction of the apparatus explained in Figures 2 to 4 are similar to the one explained in connection with Figure 1, unless otherwise pointed out in the following explanation.

Figure 2 illustrates the entire apparatus, Figure 3 is a partial front view of one tube 4 and the base plate 2, and Figure 4 illustrates a cross section of the tube 4 and base plate 2 along line A-A in Figure 2. The illustrated apparatus may be installed in a motor drive, such as in a frequency converter utilized for controlling feed of electricity to an electrical motor.

Figure 2 illustrates, by way of example, that the apparatus 21 includes 16 tubes 4 arranged in parallel to partly penetrate into the base plate of the evaporator 2 via a second surface 22 of the evaporator 2. As best seen in Figure 3, at least two channels (illustrated by dotted lines) of the tubes are thereby embedded into the evaporator 2. These embedded channels work as evaporation channels 6, receiving a heat load from one or more electric components 23 attached to a first surface 24 of the base plate 2. The remaining channels located outside of the evaoprator 2 work as condenser channels 7 which transfer heat from the fluid into air 25 flowing between the condenser channels 7. In order to enhance the transfer of heat into the air 25, fins 26 are preferably arranged to extend between the condenser channels 7 of adjacent tubes 4, as illustrated in Figure 2.

Figure 4 illustrates the fluid flow in more detail. The number of channels and the dimensions of the channels and the other elements may, in practice, vary significantly from what is illustrated in Figure 4. The hollow sections 8 and 9 at the first 10 and second 11 ends of the tubes work as connecting parts allowing fluid to pass between the evaporator channels 6 and the condenser channels 7 without a need for providing the tubes or the apparatus with external fluid distribution elements outside the tubes 4 for this purpose. This makes it possible to obtain a compact and efficient apparatus. Naturally, in some embodiments it is possible to have a hollow section 8 or 9 in only one end of the tubes and a traditional external fluid distribution element in the other end of the tubes, as an extension of the tubes, for instance.

In order to ensure an even distribution of fluid within the entire apparatus, the apparatus 21 illustrated in Figures 2 to 4 is provided with a manifold 27 extending through adjacent side walls of the tubes 4. The manifold 27 interconnects at least one channel of each tube 4 with each other and allows fluid to flow between all tubes. To arrange the manifold in this way has the advantage that the manifold does not require any additional space outside the ends of the tubes 4, for instance. Advantageously, the manifold 27 consists of a hole extending through the base plate of the evaporator 2 and the parts of the tubes 4 (evaporator channels 6) which penetrate into the evaporator 2, as illustrated in Figures 2 to 4. In this way the need for using separate tubes that need to be attached to the holes in the tubes and additionally sealed against leakage at each such hole can be avoided.

In Figure 2 it is assumed by way of example, that the end of the hole (bore) which works as the manifold 27 is plugged with a suitable plug 28. However, in order to add or remove fluid to the channels of the apparatus 21 an additional filling valve 29 provides access to one or more of the channels of the tubes 4 and/or the manifold 27. Depending on the implementation and the available space, the filling valve 29 may naturally work as the plug that plugs the end of the manifold 27, in which case it is located where the plug 28 is illustrated in Figure 2.

The apparatus illustrated in Figures 2 to 4 may be manufactured such that an evaporator 2 with a base plate having a plurality of parallel grooves in the second surface 22 is produced. This may be carried out by extrusion of aluminum, for instance.

A plurality of tubes 4 with internal longitudinal walls 5 are produced. The tubes 4 may be MPE (Multi Port Extruded) tubes which have been manufactured by extruding aluminum, for instance.

The hollow sections 8 and 9 are produced in the selected end (or both ends) of the tubes 4 by first removing the internal walls 5 from the end of the tube. This can be done by milling with a water jet, for instance. After this the end is plugged 30 by welding, for instance, such that fluid leakage from the hollow sections 8 and 9 to the outside can be avoided.

The tubes 4 are placed into the grooves in the evaporator 2 and attached to the grooves by brazing, for instance. In case a manifold 27 is also produced by drilling through the base plate of the evaporator 2 and the parts of the tubes 4 that penetrate into the evaporator 2, then additional attention needs to be paid during the brazing to ensure that leak proof interfaces are obtained between the base plate 2 and the tubes 4. Finally, the plug 28 may be welded to close the end of the manifold 27.

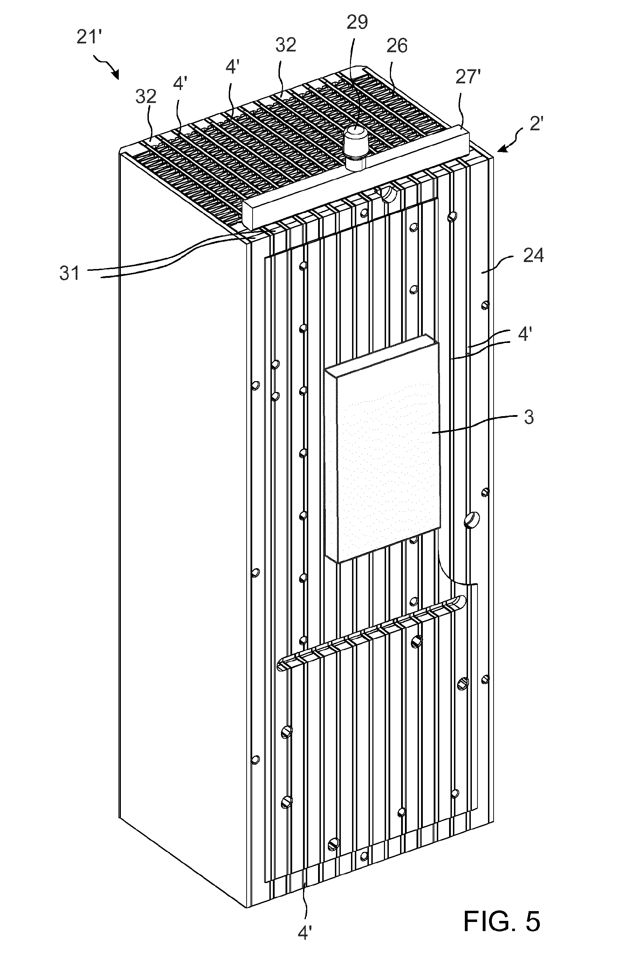

Figures 5 to 8 illustrate a second embodiment of an apparatus. The embodiment of Figures 5 to 8 is very similar to the one explained in connection with Figures 1 to 4. Therefore, the embodiment of Figures 5 to 8 will be explained mainly by pointing out the differences between these embodiments.

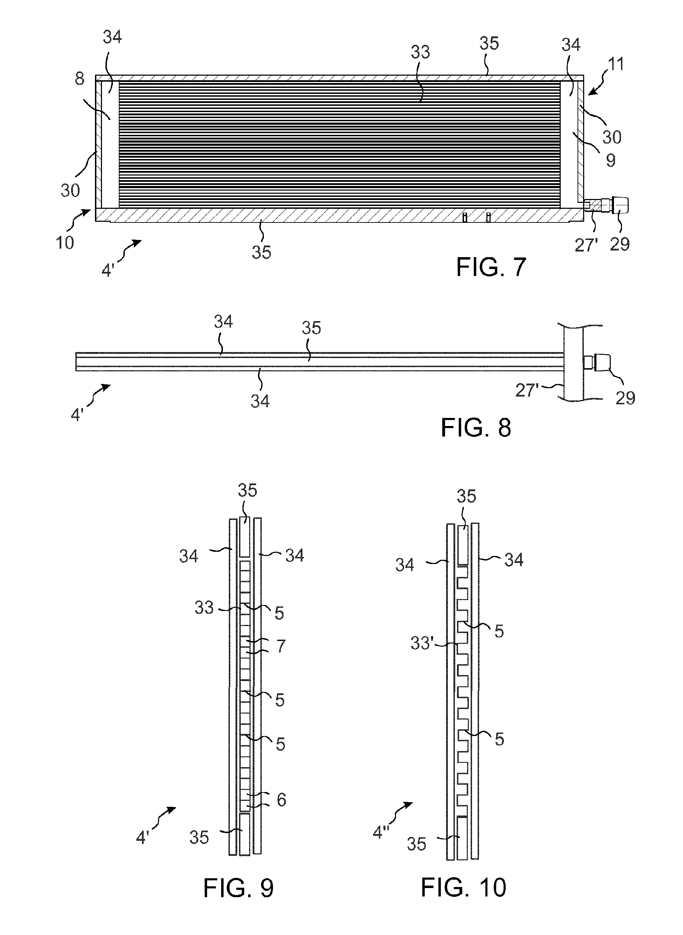

Figure 5 illustrates the entire apparatus 21', Figure 5 is a partial cross section illustrating the tubes 4' and the elongated spacer elements 31 between the tubes, and Figures 7 to 8 illustrate the tubes 4' in more detail.

In the second embodiment, the tubes 4' extend through the evaporator 2'. In the illustrated example the evaporator 2' comprises a plurality of elongated spacer elements 31 which are arranged between the tubes 4' to keep the tubes apart from each other. Therefore, the tubes 4' partly penetrate into the evaporator 2' (are located between the spacers of the evaporator), and the channels located in these parts of the tubes 4' are evaporator channels 6 that are embedded into the evaporator 2', and the other channels of the tubes are condenser channels 7, located outside of the evaporator 2'.

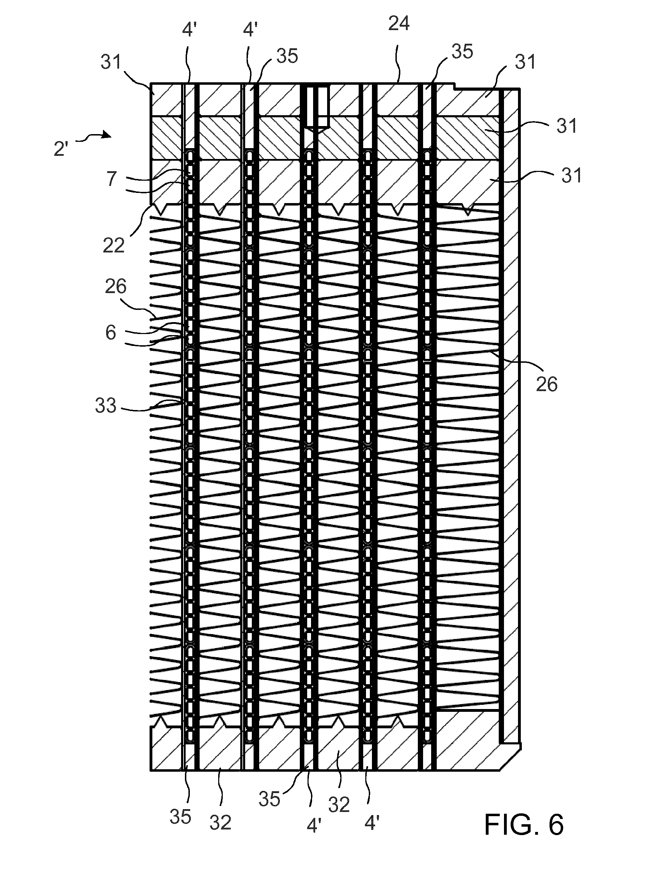

Similarly, as in the previous embodiment, fins 26 extend between condenser channels 7 of adjacent tubes 4'. Additionally, secondary spacer elements 32 may be arranged between the condenser channels 7' of the adjacent tubes at the lower edge of the tubes, as illustrated in Figure 6.

The second embodiment utilizes an alternative way of implementing a manifold 27'. As best seen in Figure 5, the manifold 27' may be arranged as an extension of the tubes 4' to allow fluid flow via the manifold between the hollow sections of the tubes 4'. The manifold 27' may also be provided with a filling valve 29 providing access to the channels of the tubes 4' from the outside of the apparatus 21'.

Figures 9 and 10 illustrate alternative tube designs. In the following, it is by way of example assumed that the tube design according to figure 9 is utilized in the second embodiment of the apparatus, as illustrated in Figures 5 to 8. However, as an alternative, it is possible to utilize the tube design of Figure 10 in the second embodiment.

Figure 9 illustrates the assembly of a tube 4'. A MPE (Multi Port Extruded) tube which has been manufactured by extruding aluminum, for instance, is utilized as a wall element 33 between a pair of parallel plates 34. The MPE tube provides the tube 4' with a plurality of internal longitudinal walls 5. These internal longitudinal walls divide the tube 4' into channels, of which some are evaporator channels 6 and some condenser channels 7, as has been explained in connection with the embodiment of Figures 1 to 4.

The longitudinal length of the wall element 33 is shorter than the longitudinal length of the plates 34, as best seen in Figure 7. Thus, hollow sections 8 and 9 are formed at the opposite ends of the tube 4', without any need to remove parts of the internal walls 5 (as in the first embodiment).

The plates 34 and the spacer elements 35 arranged between the plates 34 along opposite first edges of the plates 34, together with plug elements 30 (provided by attaching plates by welding, for instance) arranged along opposite second edges of the plates 34 together delimit a fluid tight space within the tube 4'. However, naturally a hole for allowing fluid communication via the manifold 27' may be provided in the tube 4'. The different parts of the tube 4' may be soldered together, for instance.

After production of a sufficient number of tubes 4', spacer elements 31, secondary space elements 32 and fins 26 may be arranged between such tubes in order to assemble the apparatus 2' illustrated in Figures 5 to 8. The different parts of the apparatus 2' may be soldered together.

The alternative tube design illustrated in Figure 10 is very similar to the one illustrated in Figure 9. However, in Figure 10 the wall element 33' used in the tube 4" is not a MPE tube, but instead a corrugated plate, for instance. By shaping the plate into a suitable form the longitudinal internal walls 5 of the pipe 4" can be produced.

The spacers 35 and plug elements used in tube 4" may be similar as explained in connection with tube 4', and the longitudinal length of the wall element 33' is shorter than the longitudinal length of the plates 34 in order to produce the hollow sections 8 and 9 at opposite ends of the tube 4".

It is to be understood that the above description and the accompanying figures are only intended to illustrate the present invention. It will be obvious to a person skilled in the art that the invention can be varied and modified without departing from the scope of the invention.

## Claims

1. An apparatus (1, 21, 21') comprising:
an evaporator (2, 2') with a first surface (24) for receiving a heat load (3) from one or more electric components (3),
tubes (4, 4', 4") having internal longitudinal walls (5) dividing the tubes into channels, the tubes (4, 4', 4") partly penetrate into the evaporator (2, 2') for providing evaporator channels (6) which are embedded into the evaporator (2, 2') and condenser channels (7) which are located outside of the evaporator (2, 2'), and
connecting parts at first (10) and second (11) ends of the tubes for passing fluid from the evaporator channels (6) into the condenser channels (7) and for passing fluid from the condenser channels (7) into the evaporator channels (6), **characterized in that**
the connecting parts include hollow sections (8, 9) located within the tubes (4, 4', 4"), each hollow section (8, 9) connecting the channels (6, 7) of a tube (4, 4', 4") to each other in the vicinity of an end of the tube (4, 4', 4") in order to allow fluid to flow between the channels (6, 7) of the tube via the hollow section (8, 9).

2. The apparatus according to claim 1, **characterized in that** the apparatus is provided with a manifold (27, 27') extending between the tubes (4, 4', 4") for allowing fluid to flow between at least one channel (6, 7) of each tube (4, 4', 4") via the manifold.

3. The apparatus according to claim 1, **characterized in that** the apparatus (2) is provided with a manifold (27) consisting of a hole extending through the evaporator (2) and the parts of the tubes (4) which penetrate into the evaporator (2) for allowing fluid to flow between evaporator channels (6) of different tubes via the manifold.

4. The apparatus according to claim 1, **characterized in that** the apparatus (21') is provided with a manifold (27') arranged as an extension of the tubes (4', 4") to allow fluid to flow via the manifold (27') between the hollow sections (8, 9) of the tubes.

5. The apparatus according to one of claims 1 to 4, **characterized in that** the apparatus (1, 21, 21') comprises fins (26) extending between the condenser channels (7) of adjacent tubes (4, 4', 4").

6. The apparatus according to one of claims 1 to 5, **characterized in that** the apparatus comprises at least one filling valve (29) providing access to at least one channel (6, 7) or manifold (27, 27') of the apparatus for filling the at least one channel (6, 7) or manifold (27, 27') with fluid.

7. The apparatus according to one of claims 1 to 6, **characterized in that** at least some of the channels (6, 7) have capillary dimensions.

8. The apparatus according to one of claims 1 to 7, **characterized in that** at least one of the tubes (4', 4") comprises:
a pair of plates (34) with spacer elements (35) arranged between the plates (34) along opposite first edges of the plates, and with plug elements (30) along the opposite second edges of the plates (34), the spacer elements (35) and the plug elements (30) adjoin the plates (34) to delimit a fluid tight space, and
a wall element (33, 33') arranged in the fluid tight space, the wall element comprising a plurality of internal walls (5) which form longitudinal internal walls (5) into the tube (4', 4"), the longitudinal length of the wall element (33, 33') being shorter than the longitudinal length of the plates (34) for forming hollow sections (8, 9) between the plug elements (30) and the wall element (33, 33').

9. The apparatus according to one of claims 1 to 8, **characterized in that** the evaporator (2) comprises a plate with grooves into which the tubes (4) are arranged for providing evaporator channels (6) which are embedded into the evaporator (2).

10. The apparatus according to one of claims 1 to 9, **characterized in that** the evaporator (2') comprises a plurality of elongated spacer elements (31) arranged between the tubes (4', 4"), and that the spacer elements (31) and the tubes (4', 4") together form said first surface (24).

## Amended claims

### Amended claims in accordance with Rule 137(2) EPC.

**1.** An apparatus (1, 21, 21') comprising:
an evaporator (2, 2') with a first surface (24) for receiving a heat load (3) from one or more electric components (3),
tubes (4, 4', 4") having internal longitudinal walls (5) dividing the tubes into channels, the tubes (4, 4', 4") partly penetrate into the evaporator (2, 2') for providing evaporator channels (6) which are embedded into the evaporator (2, 2') and condenser channels (7) which are located outside of the evaporator (2, 2'),
connecting parts at first (10) and second (11) ends of the tubes for passing fluid from the evaporator channels (6) into the condenser channels (7) and for passing fluid from the condenser channels (7) into the evaporator channels (6), and
fins (26) extending between the condenser channels (7) of adjacent tubes (4, 4', 4"), **characterized in that**
the connecting parts include hollow sections (8, 9) located within the tubes (4, 4', 4"), each hollow section (8, 9) connecting the channels (6, 7) of a tube (4, 4', 4") to each other in the vicinity of an end of the tube (4, 4', 4") in order to allow fluid to flow between the channels (6, 7) of the tube via the hollow section (8, 9).

**2.** The apparatus according to claim 1, **characterized in that** the apparatus is provided with a manifold (27, 27') extending between the tubes (4, 4', 4") for allowing fluid to flow between at least one channel (6, 7) of each tube (4, 4', 4") via the manifold.

**3.** The apparatus according to claim 1, **characterized in that** the apparatus (2) is provided with a manifold (27) consisting of a hole extending through the evaporator (2) and the parts of the tubes (4) which penetrate into the evaporator (2) for allowing fluid to flow between evaporator channels (6) of different tubes via the manifold.

**4.** The apparatus according to claim 1, **characterized in that** the apparatus (21') is provided with a manifold (27') arranged as an extension of the tubes (4', 4") to allow fluid to flow via the manifold (27') between the hollow sections (8, 9) of the tubes.

**5.** The apparatus according to one of claims 1 to 4, **characterized in that** the apparatus comprises at least one filling valve (29) providing access to at least one channel (6, 7) or manifold (27, 27') of the apparatus for filling the at least one channel (6, 7) or manifold (27, 27') with fluid.

**6.** The apparatus according to one of claims 1 to 5, **characterized in that** at least some of the channels (6, 7) have capillary dimensions.

**7.** The apparatus according to one of claims 1 to 6, **characterized in that** at least one of the tubes (4', 4") comprises:
a pair of plates (34) with spacer elements (35) arranged between the plates (34) along opposite first edges of the plates, and with plug elements (30) along the opposite second edges of the plates (34), the spacer elements (35) and the plug elements (30) adjoin the plates (34) to delimit a fluid tight space,and
a wall element (33, 33') arranged in the fluid tight space, the wall element comprising a plurality of internal walls (5) which form longitudinal internal walls (5) into the tube (4', 4"), the longitudinal length of the wall element (33, 33') being shorter than the longitudinal length of the plates (34) for forming hollow sections (8, 9) between the plug elements (30) and the wall element (33, 33').

**8.** The apparatus according to one of claims 1 to 7, **characterized in that** the evaporator (2) comprises a plate with grooves into which the tubes (4) are arranged for providing evaporator channels (6) which are embedded into the evaporator (2).

**9.** The apparatus according to one of claims 1 to 8, **characterized in that** the evaporator (2') comprises a plurality of elongated spacer elements (31) arranged between the tubes (4', 4"), and that the spacer elements (31) and the tubes (4', 4") together form said first surface (24).
